(19) **Europäisches Patentamt / European Patent Office / Office européen des brevets**

(11) **EP 1 251 402 B1**

(12) **EUROPEAN PATENT SPECIFICATION**

(45) Date of publication and mention
of the grant of the patent:
**24.10.2007 Bulletin 2007/43**

(51) Int Cl.:
***G03F 7/20*** (2006.01)

(21) Application number: **02252340.1**

(22) Date of filing: **28.03.2002**

(54) **Lithographic apparatus and device manufacturing method**

Lithographischer Apparat und Verfahren zur Herstellung einer Vorrichtung

Appareil lithographique et méthode de fabrication d'un dispositif

(84) Designated Contracting States:
**DE FR GB IT NL**

(30) Priority: **30.03.2001 EP 01303036**

(43) Date of publication of application:
**23.10.2002 Bulletin 2002/43**

(73) Proprietor: **ASML Netherlands B.V.**
**5504 DR Veldhoven (NL)**

(72) Inventors:
• **Baselmans, Johannes Jacobus Matheus**
**5688 GG Oirschot (NL)**
• **Engelen, Adrianus Franciscus Petrus**
**5615 SR Eindhoven (NL)**

• **Cramer, Hugo Augustinus Joseph**
**5646 HM Eindhoven (NL)**
• **Finders, Jozef Maria**
**5509 NJ Veldhoven (NL)**
• **Kohler, Carsten**
**5508 VL Veldhoven (NL)**

(74) Representative: **Leeming, John Gerard**
**J.A. Kemp & Co.**
**14 South Square**
**Gray's Inn**
**London WC1R 5JJ (GB)**

(56) References cited:
**WO-A-00/31592**          **US-A- 5 444 538**
**US-A- 6 115 108**

**Description**

The present invention relates to a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-adressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus - commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

When performing imaging in a lithographic projection apparatus, despite the great care with which the projection system is designed and the very high accuracy with which the system is manufactured and controlled during operation, the image can still be subject to aberrations such as, for example, distortion (i.e. a non-uniform image displacement in the target portion at the image plane: the XY-plane), lateral image shift (i.e. a uniform image displacement in the target portion at the image plane), image rotation, asymmetric magnification, and focal plane deformation (i.e. a non-uniform image displacement in the Z-direction, for instance due to field curvature). Notice that, in general, image errors are not necessarily uniform, and can vary as a function of position in the image field. Distortion and focal plane deformation can lead to overlay and focus errors, for example overlay errors between different mask structures, and line-width errors. As the size of features to be imaged decreases, these errors can become intolerable.

Consequently, it is desirable to provide compensation (such as adjustment of the projection system and/or substrate) to correct for, or at least attempt to minimize, these errors. This presents the problems of first measuring the errors and then calculating appropriate compensation. Previously, alignment systems were used to measure the displacements in the image field of alignment marks. However, alignment marks typically consist of relatively large features (of the order of a few microns), causing them to be very sensitive to aberrations of the projection system. The alignment marks are unrepresentative of the actual features being imaged, and because the imaging errors depend *inter alia* on feature size, the displacements measured and compensations calculated did not necessarily optimize the image for the desired features.

Another problem occurs when, for instance because of residual manufacturing errors, the projection system features an asymmetric variation of aberration over the field. These variations may be such that at the edge of the field the aberration becomes intolerable.

A further problem occurs when using phase-shift masks (PSM's). Conventionally, the phase shift in such masks has to be precisely 180 degrees. The control of the phase is critical; deviation from 180 degrees is detrimental. PSM's, which are expensive to make, must be carefully inspected, and any masks with substantial deviation in phase shift from 180 degrees will generally be rejected. This leads to increased mask prices.

A further problem occurs with the increasing requirements imposed on the control of critical dimension ("CD"). The critical dimension is the smallest width of a line or the smallest space between two lines permitted in the fabrication of a device. In particular the control of the uniformity of CD, the so-called "CD uniformity", is of importance. In lithography, efforts to achieve better line width control and CD uniformity have recently led to the definition and study of particular error types occurring in features, as obtained upon exposure and processing (see description above). For instance, such image error types are an asymmetric distribution of CD over a target portion, an asymmetry of CD with respect to defocus (which results in a tilt of Bossung curves), asymmetries of CD within a feature comprising a plurality of bars (commonly referred to as Left-Right asymmetry), asymmetries of CD within a feature comprising either two or five bars (commonly known as L1-L2 and L1-L5, respectively), differences of CD between patterns that are substantially directed along two mutually orthogonal directions (for instance the so-called "H-V" lithographic error), and for instance a variation of CD within a feature, along a bar, commonly known as "C-D". Just as the aberrations mentioned above, these errors are generally non-uniform over the field. For simplicity we will hereafter refer to any of these error types - including the errors such as, for example, distortion, lateral image shift, image rotation, asymmetric magnification, and focal plane deformation - as "lithographic errors", i.e. feature-deficiencies of relevance for the lithographer.

Lithographic errors are caused by specific properties of the lithographic projection apparatus. For instance, the aberration of the projection system, or imperfections of the patterning means and imperfections of patterns generated by the patterning means, or imperfections of the projection beam may cause lithographic errors. However, also nominal properties (i.e. properties as designed) of the lithographic projection apparatus may cause unwanted lithographic errors. For instance, residual lens aberrations which are part of the nominal design may cause lithographic errors. For reference hereafter, we will refer to any such properties that may cause lithographic errors as "properties".

As mentioned above, the image of a pattern can be subject to aberrations of the projection system. A resulting variation of CD (for example, within a target portion) can be measured and subsequently be mapped to an effective aberration condition of the projection system which could produce said measured CD variation. A compensation can than be provided to the lithographic projection system such as to improve CD uniformity. Such a CD-control method is described in United States Patent US 6,115,108 which is the closest prior art for the invention and comprises imaging a plurality of test patterns at each field point of a plurality of field points, a subsequent processing of the exposed substrate, and a subsequent CD measurement for each of the imaged and processed test patterns. Consequently, the method is time consuming and not suitable for in-situ CD control. With increasing demands on throughput (*i.e.* the number of substrates that can be processed in a unit of time) as well as CD uniformity, the control, compensation and balancing of lithographic errors must be improved, and hence, there is the problem of furthering appropriate control of properties.

It is an object of the present invention to alleviate the above problems.

This and other objects are achieved according to the invention in a device manufacturing method according to claim 1.

Although preferably all lithographic errors shall be minimized, this will in general not be possible since there are not enough compensators available. Therefore, it is useful to define a merit function which suitably describes the quality of the imaging process in terms of a sum of weighted lithographic errors. A weight assigned to a lithographic error shall be indicative of the relative importance of that lithographic error. Compensation can be used to optimize (i.e. to minimize the value of) the merit function, such as to optimize the imaging and the resulting lithographic process. As explained above, lithographic errors depend on properties (of the lithographic projection apparatus) and can be calculated using, for instance, commercially available lithography simulation software such as Prolith™, Solid-C™ or LithoCruiser™. For instance, given specific (critical) pattern features to be imaged, given specific pattern errors (such as phase errors with a phase shift mask), given the aberration of the projection system, given the data concerning the radiation sensitive layer on the substrate, and given the radiation beam properties such as radiation energy and wavelength (i.e. given a set of properties), predictions regarding CD uniformity or feature-specific deficiencies can be made with these simulation programs. By introducing small variations of the properties (for instance, by introducing small variations of the projection lens aberration) and calculating the corresponding changes in the lithographic errors, sensitivity coefficients quantifying the relationship between a lithographic error and said properties can be established. Obtaining information on properties comprises (in-situ) measuring of properties. For example, the actual aberration condition of the projection system can be measured in-situ using a suitable technique such as one of those disclosed in European Patent Application Number EP 1 128 217 A2 and in P. Venkataraman, et al., "Aberrations of steppers using Phase Shifting Point Diffraction Interferometry", in Optical Microlithography XIII, J. Progler, Editor, Proceedings of SPIE Vol. 4000, 1245-1249 (2000). An advantage of the method according to the present invention is that the method does not necessarily comprise the step of processing an exposed substrate.

Key to the control of lithographic errors is the ability to compensate, or at least affect, these lithographic errors. Any means enabling such control will be referred to hereafter as compensation means. By the term "compensation" mentioned above any change of a property caused by activating a compensation means is meant, and we will use the term compensation in this sense hereafter. Compensation means suitable for use with a lithographic projection apparatus are, for instance, means enabling a fine positioning (an X-, Y-, and Z- translation, and a rotation about the X-, Y-, and Z-axis) of the holder for holding the patterning means, means enabling a similar fine positioning of the substrate table, means to move or deform optical elements (in particular, to fine position, using an X-, Y-, and Z- translation/rotation, optical elements of the projection system), and, for instance, means to change the energy of the radiation impinging on the target portion. However, suitable compensation means are not limited to said examples: for instance, means to change the wavelength of the radiation beam, means to change the pattern, means to change the index of refraction of gas-filled spaces traversed by the projection beam, and means to change the spatial distribution of the intensity of the radiation beam may also serve to affect lithographic errors.

The optimization calculation is based on varying the available compensators. The calculation comprises minimization of the merit function. Since the merit function is available as a mathematical expression (relating lithographic errors to compensations), standard minimization routines such as a "weighted least squares optimization" can be used to find a set of compensators at which the merit function has a minimum.

By performing the optimization calculation, the quality of the imaging can be objectively improved, as defined by the merit function. The compensation enables, for example, one component of aberration of the projection system to be increased in order to decrease the effect of another aberration component, such that, on balance, the image quality as a whole is improved. In other words, preferably the improvement in one aspect of the imaging more than compensates for a change of a different aspect of the imaging. According to another example, the patterning means can be translated, rotated and/or tilted (a form of rotation) in order to minimize the overall local displacement of the image from it's ideal position across the whole image field. In a further example, linear comatic aberration can be introduced within the projection system to reduce or eliminate left-right asymmetry caused by 3-wave aberration. In a further example, spherical aberration can be introduced to compensate for "Bossung tilt" caused by a phase shift error in a phase shift mask, which would otherwise have to be rejected. Bossung tilt is the lithographic error whereby at best focus position there is a gradient in the graph of exposed feature width against focus position (said graph being a so-called Bossung curve).

Said properties (of, for example, the projection system) can be stored in a database for use in optimization calculations for exposures using the apparatus containing that projection system. The sensitivity coefficients which quantify the relationship between those properties and a lithographic error can also be stored in a database as sets or families of sensitivity coefficients depending on pattern feature type, size, orientation, illumination mode, numerical aperture and so on.

According to a further aspect of the invention there is provided a lithographic projection apparatus according to claim 16.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm).

Embodiments of the invention will now be described, by way of example only, with reference to the accompanying schematic drawings in which:

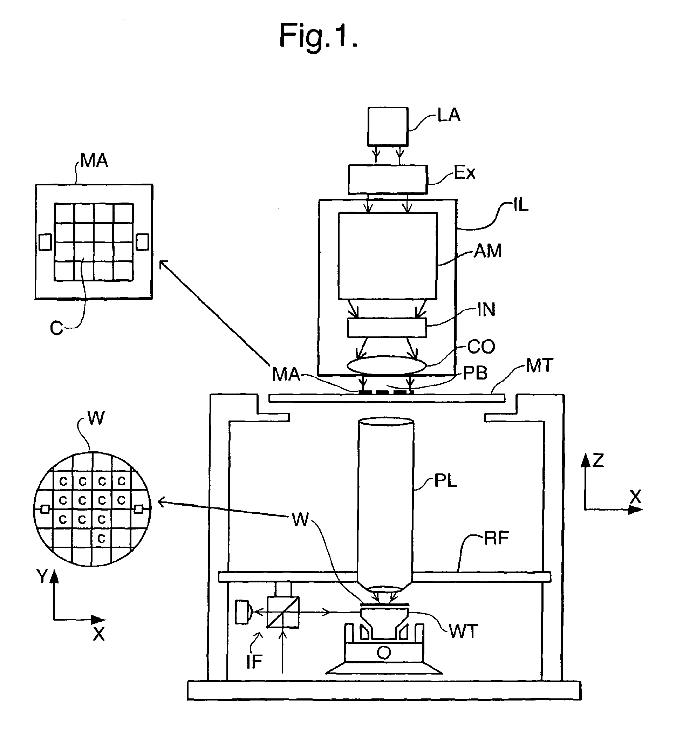

> Figure 1 depicts a lithographic projection apparatus according to an embodiment of the invention; and

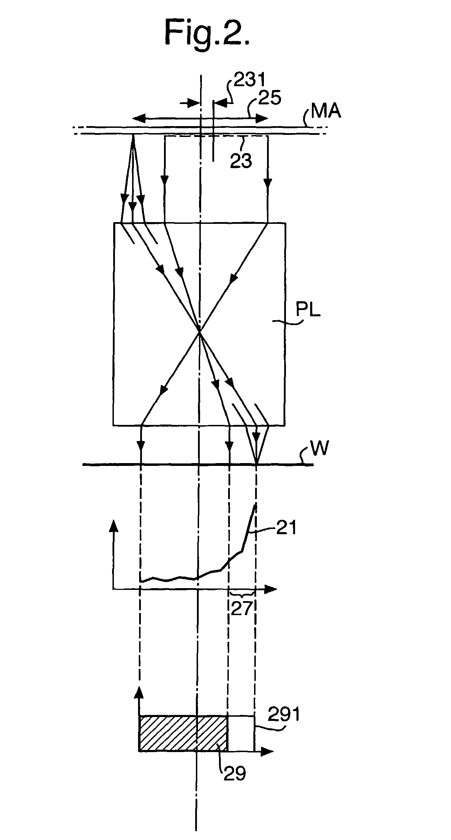

> Figure 2 depicts the imaging of a decentered pattern, where the decenter is the compensator for alleviating the effects of a lithographic error. The graph at the bottom shows the boundary of the area of *x, y* field points contributing to the merit function, in relation to the boundary of the full field target portion. The horizontal axis represents the *x*-position along the slit, the vertical axis represents the *y*-position (a position along the scanning direction). The graph in the middle shows a plot of a lithographic error, which is asymmetrically distributed along the *x*-axis. The horizontal axis represents the *x*-position along the slit, the vertical axis represents the magnitude of a lithographic error.

Embodiment 1

Figure 1 schematically depicts a lithographic projection apparatus according to a particular embodiment of the invention. The apparatus comprises:

> · a radiation system Ex, IL, for supplying a projection beam PB of radiation (*e.g.* UV radiation such as for example generated by an excimer laser operating at a wavelength of 248 nm, 193 nm or 157 nm, or by a laser-fired plasma source operating at 13,6 nm). In this particular case, the radiation system also comprises a radiation source LA;
> · a first object table (mask table) MT provided with a mask holder for holding a mask MA (*e.g.* a reticle), and connected to first positioning means for accurately positioning the mask with respect to item PL;
> · a second object table (substrate table) WT provided with a substrate holder for holding a substrate W (*e.g.* a resist-coated silicon wafer), and connected to second positioning means for accurately positioning the substrate with respect to item PL;
> · a projection system ("lens") PL (*e.g.* a quartz and/or $CaF_2$ lens system or a catadioptric system comprising lens elements made from such materails, or a mirror system) for imaging an irradiated portion of the mask MA onto a target portion C *(e.g.* comprising one or more dies) of the substrate W.

As here depicted, the apparatus is of a transmissive type (*i.e.* has a transmissive mask). However, in general, it may also be of a reflective type, for example (with a reflective mask). Alternatively, the apparatus may employ another kind of patterning means, such as a programmable mirror array of a type as referred to above.

The source LA (*e.g.* a UV excimer laser, a laser-fired plasma source, a discharge source, or an undulator or wiggler provided around the path of an electron beam in a storage ring or synchrotron) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;

2. In scan mode, essentially the same scenario applies, except that a given target portion C is not exposed in a single "flash". Instead, the mask table MT is movable in a given direction (the so-called "scan direction", *e.g.* the y direction) with a speed $v$, so that the projection beam PB is caused to scan over a mask image; concurrently, the substrate table WT is simultaneously moved in the same or opposite direction at a speed $V = Mv$, in which $M$ is the magnification of the lens PL (typically, $M = 1/4$ or $1/5$). In this manner, a relatively large target portion C can be exposed, without having to compromise on resolution.

The image distortion and focal plane deformation occurring in the projected image depend on various factors, such as the lens aberration, illumination mode used [e.g. numerical aperture (NA), pupil filling (sigma setting)], and the type and size of the feature imaged. The lens aberration can be expressed in terms of the Zernike expansion, in which the aberrated wavefront is given by the sum of a plurality of Zernike polynomials (functions of position in the image field) each multiplied by a respective Zernike coefficient. The image X, Y and Z displacements can be modeled by the following linear expressions:

$$dX(x,y) = \sum_j \frac{\partial X}{\partial Zj} \cdot Zj(x,y) \qquad (1)$$

$$dY(x,y) = \sum_j \frac{\partial Y}{\partial Zj} \cdot Zj(x,y) \qquad (2)$$

$$dF(x, y) = \sum_j \frac{\partial F}{\partial Zj} \cdot Zj(x, y) \qquad\qquad (3)$$

where:

$dX, dY, dF$ are the respective X, Y and Z displacements;
$(x, y)$ is a specific field location;
$j$ is an index for the jth Zernike aberration;
$Zj$ is an aberration coefficient, known as a Zernike coefficient, representative of the contribution of the $j$th Zernike polynomial to the wavefront aberration at field point $(x,y)$; and

$\dfrac{\partial}{\partial Z_j}$ is the partial derivative of the displacement with respect to the jth Zernike aberration.

Notice that $dX, dY$ and $dF$ are lithographic errors, and that the Zemike coefficients $Z_j$ are properties (of the imaging system including an object and image plane).

A further refinement is to write the Z-displacement $dF$ as two components $dV$ and $dH$ which are the optimal focus positions along the Z-axis for so-called vertical and horizontal lines, respectively; these are features extending along the $y$ and $x$ axes, respectively. Using this, and a different notation, the above equations can be rewritten, for the 37 Zernike aberrations, as:

$$dX(x, y) = A1.Z1(x, y) + A2.Z2(x, y) + \ldots + A37.Z37(x, y) \qquad (4)$$

$$dY(x, y) = B1.Z1(x, y) + B2.Z2(x, y) + \ldots + B37.Z37(x, y) \qquad (5)$$

$$dH(x, y) = C1.Z1(x, y) + C2.Z2(x, y) + \ldots + C37.Z37(x, y) \qquad (6)$$

$$dV(x, y) = D1.Z1(x, y) + D2.Z2(x, y) + \ldots + D37.Z37(x, y) \qquad (7)$$

where the partial derivatives have been replaced by equivalent sensitivity coefficients Ai, Bi, Ci, Di which express *inter alia* the effects of illumination mode, NA, sigma and pattern feature size and type.

The procedure according to this embodiment of the invention is as follows:

1. The intrinsic aberration of the lens is measured using a suitable technique, such as one of those disclosed in European Patent Application EP 1 128 217 A2, to obtain the Zernike coefficients (or previously measured values can be used). The Zernike coefficients are then multiplied by their respective Zernike functions to obtain a "field map" of the Zernike aberrations ($Zj(x,y)$ in the above notation), which is stored. This information depends only on the lens and is independent of the illumination and features.

2. For the exposure of a specific pattern feature, at a particular illumination setting, the sensitivity coefficients Ai, Bi, Ci, Di are calculated using known computational techniques, such as image simulation software, for example the program known as Solid-C™ supplied by Sigma-C GmbH of Germany. Other suitable software packages, such as one known as Prolith™ or LithoCruiser™, may alternatively be used. These sensitivity coefficients do not depend on the field location, so only need to be calculated once per feature and illumination setting combination, and are then stored in a database.

3. For the exposure of a specific pattern feature, at a particular illumination setting, the field distribution of the X, Y and Z-displacements is calculated by means of the models, for example equations (4) to (7), and using the field map from step 1 and the sensitivity coefficients from step 2. A calculation is performed to determine what compensator to provide to minimize the image displacements for the whole field. Such a calculation can be based on a merit function of the form

$$S = w1 \sum_{x,y} (dX(x,y))^2 + w2 \sum_{x,y} (dY(x,y))^2 + w3 \sum_{x,y} (dH(x,y))^2 + w4 \sum_{x,y} (dV(x,y))^2 \quad (8)$$

where $wi$ ($i$ = 1,2,3,4) are weights, and the sum over an appropriately chosen grid of field coordinates $x,y$ ensures an averaging of the lithographic error over a target portion. The weights can be chosen at the discretion of the lithographer. For $dX$, $dY$, $dH$ and $dV$ one can substitute expressions (4), (5), (6) and (7) respectively. A simple compensator is, for instance, the Z-position of the substrate, commonly called "focus". It is well known that a change of focus, by moving the substrate through a distance $dZ$, affects primarily the value of $Z4$, and in this particular case, the error is independent of the $x,y$ position in the field. So, in order to incorporate the effect of the compensator $dZ$ on the merit function (through the effects that $dZ$ has on $dX$, $dY$, $dH$ and $dV$), one has to substitute $Z4 + F4(dZ,x,y)$ for Z4 in the expressions (4), (5), (6) and (7), as used in equation (8), where the function $F4(dZ,x,y)$ is simply given by

$$F4(dZ,x,y) = a4 \cdot dZ \qquad (9)$$

a4 being a (field independent) constant of proportionality which follows from aberration theory. Notice, however, that in practice the compensation $dZ$ will, besides this primary impact on Z4, also affect, as a secondary effect, other Zernike aberration coefficients. Generally, the effect of a compensator $C$ comprises a primary effect on a few Zemike coefficients and a secondary change of balance between the other Zernike aberration coefficients. So, the effect of a set ofn compensators $Ci$, with $i$ =1,2,..,$n$, on the merit function can be visualized by replacing $Zj(x,y)$ in the expressions (4), (5), (6) and (7), as used in equation (8), by $Zj(x,y,C1',C2',...,Ci',...,C'n)$, where

$$Zj(x,y,C1',C2',\cdots,Ci',\cdots,Cn') = Zj(x,y) + \sum_{i=1}^{n} Fj(Ci',x,y) \qquad . \qquad (10)$$

The functions $Fj(Ci',x,y)$ are (to good approximation) linearly dependent on $Ci'$ and vanish for $Ci'$=0. Therefore, to a good approximation one obtains:

$$Zj(x,y,C1',C2',\cdots,Ci',\cdots,Cn') \approx Zj(x,y) + \sum_{i=1}^{n} Ci'Uji(x,y) \qquad (11)$$

The constants of proportionality $Uji(x,y)$ are defined by

$$Uji(x,y) = \frac{\partial Fj(Ci',x,y)}{\partial Ci}, \qquad (12)$$

and follow from the theory of aberrations or can be calculated using optical design software, such as for instance CodeV™. Notice that, in general, the constants of proportionality are field dependent. In the example above, a4 represents a special case where the constant of proportionality is field independent.

In view of the above, the merit function $S$ depends on the compensators $C1'$, $C2'$, ..., $C'n$. Then, using a standard minimization procedure such as a weighted least square optimization (see for instance the publication "Numerical Recipes in C", First Edition, by William H. Press, Brian P. Flannery, Saul A. Teukolsky, and William T. Vetterling, Cambridge University Press, 1988), values of the compensations can be found for which $S$ is at a minimum value. Next, the projection apparatus is adjusted to provide the calculated compensation. Examples of available compensators include:

  translation of the mask table (to shift the *x, y* co-ordinates);
  lens adjustment (e.g. to change the magnification and/or field curvature, using internal lens-element manipulators and/or telecentricity adjustment);
  rotation of the mask (reticle);
  adjustment of the mask height (e.g. to compensate for 3<sup>rd</sup> order distortion);
  adjustment of the mask tilt; and
  adjustment of leveling (e.g. to compensate for *z*-displacement and tilt).

For a particular pattern to be imaged, the illumination setting to be used is usually predetermined to optimize contrast. Similarly, although the pattern may have many feature types, in practice one feature type will be the most critical. At step 2, the sensitivity coefficients can be calculated for the predetermined illumination setting and the most critical feature type. Alternatively, at step 2, a family of sets of sensitivity coefficients can be derived for a range of feature types and illumination settings and stored in a database. Then the set of sensitivity coefficients for a pattern, with particular most critical feature type and predetermined illumination setting, can simply be looked up in the database of sensitivity coefficient families. The sensitivity coefficients, derived either way, can then be stored as the default values for that particular pattern. If the model of equations (4) to (7) is used there will only be 37x4 sensitivity coefficient values associated with each pattern.

Embodiment 2

As described above, a translation of the mask table (holder for the patterning means) is one of the compensators available. In one embodiment this translational degree of freedom is exploited to establish a decentered imaging of a pattern: see Fig. 2. A projection system PL of a scanning lithography apparatus is shown in Fig. 2 and is assumed to exhibit a strong asymmetric distribution 21 of, for instance, $Z7(x,y)$ along the *x*-direction. Such an asymmetry may be caused by residual manufacturing errors that occurred during the manufacturing of the projection system, and is known to be an important contributor to the lithographic error Left-Right asymmetry (LR asymmetry). If the pattern 23 that is to be imaged is smaller that the full field width 25, one can shift the pattern in the *x*-direction over a distance 231, such that the patterned beam traverses the projection system in a decentered manner. As a result, the portion 27 of the field which suffers strongly from Z7 is avoided, and the lithographic error LR asymmetry will be reduced. In this example, the merit function S will comprise a weighted term which accounts for LR asymmetry (with a weight *w* chosen by the lithographer):

$$S = \cdots + w\sum_{x,y}\left(LRasymmetry(x,y)\right)^2 + \cdots \qquad (13)$$

The compensation 231 affects, in this embodiment, the relative position of the boundary 29 of the grid of *x,y* field points (that contribute to the merit function) with respect to the boundary 291 of the full field target portion.

Embodiment 3

As described in Embodiment 1 above, displacement-compensation means are used to minimize the X, Y and Z image displacements resulting from, for instance, aberration in the lens. Effectively the plane of the image and the wafer is shifted to balance aberration effects of the lens. Alternatively, or in addition, the aberration of the lens itself can be adjusted. For example, spherical aberration adjustment and comatic aberration adjustment can be provided (spherical and comatic aberration are the lowest order even and odd aberrations, respectively). In other respects, this embodiment is the same as Embodiment 1.

Aberration adjustment will influence the distribution of all aberrations (i.e. change the values of the Zernike coefficients), so will need to be taken into account at step 1. The means of adjusting the aberration may also influence the sensitivity coefficients Ai, Bi, Ci, Di, so may need to be taken into account in step 2. Lens manipulation primarily influences the low order Zernike aberrations (Z2, Z3, Z4, Z5). The impact of these aberrations on the imaging is displacement and defocus (astigmatism), and this impact is independent of the pattern feature structure and the illumination settings.

Often it is best simply to minimize the aberration of the lens. However, as can be seen from equations (4) to (7), the ability to adjust the aberrations Zj, gives more adjustable parameters, and hence more degrees of freedom, for minimizing the displacement errors.

Embodiment 4

The invention is not limited to reducing overlay and focus errors (minimizing the displacements). Compensation can be used to reduce any lithographic effect that is detrimental to image quality. For example left-right asymmetry (LR asymmetry) caused by 3-wave aberration can be reduced by introducing linear comatic aberration within the system. In other words, increasing one aberration can be used to decrease another aberration such that, on balance, the quality as a whole of a printed feature is improved. It is then necessary to include LR asymmetry in the merit function. Let us denote an arbitrary lithographic error, that is to be minimized, by *LEj, j* = 1,2,3,4,... For instance, we may rewrite Equation (8) as

$$S = \sum_{j=1}^{4} wj(LEj)^2 \qquad (14)$$

if *dX* = *LE*1, *dY* = *LE*2, *dH* = *LE*3 and *dV* = *LE*4. One can now include LR asymmetry in the merit function with a weight w5, to be chosen by the lithographer:

$$S = \sum_{j=1}^{4} \left( wj \sum_{x,y} (LEj)^2 \right) + w5 \sum_{x,y} (LRasymmetry(x,y))^2 , \qquad (15)$$

With simulation software one can calculate the sensitivity coefficients for the lithographic error *LRasymmetry(x,y)* in analogy to equations (4) - (7), and proceed as in embodiment 1. Another example of a lithographic error which can be compensated for is the error known as Bossung tilt (also known as "iso-focal tilt"). It may occur when a phase shift mask (PSM) is used as patterning means. Ideally, the phase shift between the regions of the mask is precisely 180 degrees. Any deviation from 180 degrees phase shift will cause a Bossung tilt (i.e. even at the best focus position, there is a gradient in the graph of exposed feature width against focus position (Bossung curve); therefore the process latitude is very poor, and in practice one may have to discard the mask). However, it has been found that: (i) the phase error of a PSM; and (ii) spherical aberration (characterized by the Z9 Zernike parameter), have a similar impact on the Bossung curves, both leading to Bossung tilt. Therefore, a specific amount of spherical aberration can be introduced to cause Bossung tilt in one direction to cancel out a PSM phase error which causes Bossung tilt in the opposite direction. In this example, the merit function includes Bossung tilt, referred to hereafter as *BT(x,y)*, which is a function of lens aberrations; in analogy with, for instance, equation (4) we may write

$$BT(x,y) = P1Z1(x,y) + P2Z2(x,y) + \cdots + P9Z9(x,y) + \cdots + P37Z37(x,y) + Q.\theta \qquad (16)$$

In this example, the sensitivity coefficient P9 is relatively large with respect to the other sensitivity coefficients *Pj,j*=1,2,.. 8,10,..,37, θ is the PSM phase error , and *Q* is a sensitivity coefficient.
A compensation means which is known primarily to affect Z9 can now be used for counteracting the lithographic error Bossung tilt. If an optimal compromise between correcting for Bossung tilt, LR asymmetry, and the image shifts mentioned in embodiment 1 is to be found, the merit function shall be chosen to be

$$S = \sum_{j=1}^{4} wj \left( \sum_{x,y} (LEj)^2 \right) + w5 \sum_{x,y} (LRasymmetry(x,y))^2 + w6 \sum_{x,y} (BT(x,y))^2 \qquad (17)$$

Whilst specific embodiments of the invention have been described above, it will be appreciated that the invention may be practiced otherwise than as described. The description is not intended to limit the intention which is defined by the claims.

**Claims**

1. A device manufacturing method comprising the steps of:

   - providing a substrate (W) that is at least partially covered by a layer of radiation-sensitive material;
   providing a projection beam (PB) of radiation using a radiation system (LA, EX, IL);
   using patterning means (MA) to endow the projection beam (PB) with a pattern in its cross-section;
   projecting the patterned beam of radiation onto a target portion (c) of the layer of radiation-sensitive material using a projection system (PL),
   obtaining information on properties $(Z_j)$ of at least one of the substrate (W), the layer of radiation sensitive material, the projection beam (PB), the patterning means (MA) and the projection system (PL); and
   obtaining a plurality of sensitivity coefficients $(A_i, B_i, C_i, D_i)$ which quantify the relationship between said properties and at least one of a plurality of lithographic error (dX,dY,dH,dV) in a projected image in the radiation sensitive layer;

   **characterized by**:

   defining a merit function (S) which is a weighted sum of said plurality of lithographic errors;
   calculating a compensator (C'i) to apply to at least one of said properties to optimize the merit function, wherein said calculating step comprises calculating the effect on the merit function of the compensator on the basis of a linear approximation of the relationship between the compensator and a change of properties; and
   applying the calculated compensator to at least one of said properties.

2. A device manufacturing method according to claim 1, wherein said properties on which information is obtained are selected from the group consisting of: pattern features; mask pattern errors; the aberration of the projection system; data concerning the radiation sensitive layer on the substrate; radiation beam energy and wavelength.

3. A device manufacturing method according to claim 1 or 2, wherein said at least one lithographic error is selected from the group consisting of: feature displacement in the X,Y-plane; feature rotation; asymmetric magnification of feature; distortion; focal plane deformation; asymmetric distribution of CD over a target portion; asymmetry of CD with respect to defocus; Left-Right asymmetries of CD; L1-L2; L1-L5; differences of CD between patterns that are substantially directed along two mutually orthogonal directions; variation of CD within a feature, along a bar, commonly known as C-D; and combinations thereof.

4. A device manufacturing method according to claim 1, 2 or 3, wherein said sensitivity coefficients comprise linear constants of proportionality between said properties and said lithographic errors.

5. A device manufacturing method according to any one of the preceding claims, wherein said sensitivity coefficients comprise a plurality of families of sensitivity coefficients for at least one of: different illumination settings of the radiation system and/or projection system; and different features of the pattern to be projected

6. A device manufacturing method according to any one of the preceding claims, wherein the process of obtaining comprises at least one of: measuring; calculating; and reading from a database.

7. A device manufacturing method according to any one of the preceding claims, wherein said information on properties comprise a field map of aberration as a function of position in the image to be formed at said target portion.

8. A device manufacturing method according to any one of the preceding claims, wherein said calculation is performed to optimize the merit function for the most critical feature of the pattern to be projected.

9. A device manufacturing method according to any one of the preceding claims, wherein the compensator comprises at least one of: translation of the patterning means (MA); rotation of the patterning means (MA); translation of the substrate (W); rotation of the substrate (W); movement or deformation of optical elements, preferably optical elements of the projection system (PL); change of energy of the radiation beam; change of wavelength of the radiation beam (PB); change of index of refraction of gas-filled spaces traversed by the projection beam; change of the spatial distribution of the intensity of the radiation; change of used portion of field.

10. A device manufacturing method according to any one of the preceding claims, wherein:

said information on properties is a field map of aberration of the projection system expressed in terms of the Zernike expansion;
said lithographic error comprises at least one of: the X displacement of the pattern; the Y displacement of the pattern; the Z displacement of features of the pattern oriented in the X direction; and the Z displacement of features of the pattern oriented in the Y direction, each as a function of position in the X, Y plane of the target portion of the substrate; and
said sensitivity coefficients are the constants of proportionality giving the sensitivity of the lithographic error to each Zernike aberration component in said expansion.

11. A device manufacturing method according to any one of the preceding claims, wherein:

said merit function describes the left-right asymmetry of the pattern;
said sensitivity coefficients relate the left-right asymmetry to the position of the pattern with respect to the full field of the projection system; and
said compensator is adjustment of the position of the pattern with respect to the full field of the projection system.

12. A device manufacturing method according claim 11, wherein said compensator comprises a shift of the pattern in the X direction, such that the patterned beam traverses the projection system (PL) in a decentered manner.

13. A device manufacturing method according to any one of the preceding claims, wherein:

said merit function describes the left-right asymmetry of the pattern;
said sensitivity coefficients are the constants of proportionality giving the sensitivity of the left-right asymmetry to aberration of the projection system (PL); and
said compensator is adjustment of the linear comatic aberration of the projection system (PL).

14. A device manufacturing method according to any one of the preceding claims, wherein:

said patterning means (MA) comprises a phase shift mask;
said information on properties comprises the phase shift error of the phase shift mask;
said merit function describes Bossung tilt;
said sensitivity coefficients are the constants of proportionality giving the sensitivity of the Bossung tilt to the phase shift error and to aberration of the projection system (PL); and
said compensator is adjustment of the aberration of the projection system (PL).

15. A device manufacturing method according to claim 12, wherein said aberration of the projection system is particularly the spherical aberration, and more preferably the Zernike aberration component known as Z9.

16. A lithographic projection apparatus comprising:

a radiation system (LA, EX, IL) for providing a projection beam (PB) of radiation;
a support structure (MT) for supporting patterning means (MA), the patterning means (MA) serving to pattern the projection beam (PB) according to a desired pattern;
a substrate table (WT) for holding a substrate (W);
a projection system (PL) for projecting the patterned beam (PB) onto a target portion of the substrate (W), compensation means appliable to at least one of the support structure (MT) for supporting the patterning means (MA), the substrate table (WT), the radiation system (LA, EX, IL), the patterning means (MA) and the projection system (PL), to optimize a merit function which weighs and sums lithographic errors causing anomaly in a projected image in the radiation sensitive layer; and
a processor for calculating at least one compensator to be applied by said compensation means according to the calculating step defined in claim 1.

17. Apparatus according to claim 16, wherein said properties are selected from the group consisting of: pattern features;

mask pattern errors; the aberration of the projection system; data concerning the radiation sensitive layer on the substrate; radiation beam energy and wavelength.

**18.** Apparatus according to claim 16 or 17, wherein said at least one lithographic error is selected from the group consisting of: feature displacement in the X,Y-plane; feature rotation; asymmetric magnification of feature; distortion; focal plane deformation; asymmetric distribution of CD over a target portion; asymmetry of CD with respect to defocus; Left-Right asymmetries of CD; L1-L2; L1-L5; differences of CD between patterns that are substantially directed along two mutually orthogonal directions; variation of CD within a feature, along a bar, commonly known as C-D; and combinations thereof.

**19.** Apparatus according to claim 16, 17 or 18, wherein said sensitivity coefficients comprise linear constants of proportionality between said properties and said lithographic error.

**20.** Apparatus according to any one of claims 16 to 19, wherein said sensitivity coefficients comprise a plurality of families of sensitivity coefficients for at least one of: different illumination settings of the radiation system and/or projection system; and different features of the pattern to be projected

**21.** Apparatus according to any one of claims 16 to 20, further comprising a database of said sensitivity coefficients and/or said properties.

**22.** Apparatus according to any one of claims 16 to 21, wherein said properties comprise a field map of aberration as a function of position in the image to be formed at said target portion.

**23.** Apparatus according to any one of claims 16 to 22, wherein said processor is arranged to perform said calculation to optimize the merit function for the most critical feature of the pattern to be projected.

**24.** Apparatus according to any one of claims 16 to 23, wherein the compensator comprises at least one of: translation of the patterning means (MA); rotation of the patterning means (MA); translation of the substrate (W); rotation of the substrate (W); movement or deformation of optical elements, preferably optical elements of the projection system (PL); change of energy of the radiation beam; change of wavelength of the radiation beam; change of index of refraction of gas-filled spaces traversed by the projection beam (PB); change of the spatial distribution of the intensity of the radiation; change of used portion of field.

**25.** Apparatus according to any one of claims 16 to 24, wherein:

said properties comprise a field map of aberration of the projection system (PL) expressed in terms of the Zernike expansion;
said lithographic error comprises at least one of: the X displacement of the pattern; the Y displacement of the pattern; the Z displacement of features of the pattern oriented in the X direction; and the Z displacement of features of the pattern oriented in the Y direction, each as a function of position in the X, Y plane of the target portion of the substrate; and
said sensitivity coefficients are the constants of proportionality giving the sensitivity of the lithographic error to each Zernike aberration component in said expansion.

**26.** Apparatus according to any one of claims 16 to 25, wherein:

said merit function describes the left-right asymmetry of the pattern;
said sensitivity coefficients relate the left-right asymmetry to the position of the pattern with respect to the full field of the projection system; and
said compensator is adjustment of the position of the pattern with respect to the full field of the projection system.

**27.** Apparatus according claim 26, wherein said compensator comprises a shift of the pattern in the X direction, such that the patterned beam traverses the projection system (PL) in a decentered manner.

**28.** Apparatus according to any one of claims 16 to 27, wherein:

said merit function describes the left-right asymmetry of the pattern;
said sensitivity coefficients are the constants of proportionality giving the sensitivity of the left-right asymmetry to aberration of the projection system (PL); and
said compensator is adjustment of the linear comatic aberration of the projection system (PL).

29. Apparatus according to any one of claims 16 to 28, wherein:

said patterning means (MA) comprises a phase shift mask;
said properties comprises the phase shift error of the phase shift mask;
said merit function describes the Bossung tilt;
said sensitivity coefficients are the constants of proportionality giving the sensitivity of the Bossung tilt to the phase shift error and to aberration of the projection system (PL); and
said compensator is adjustment of the aberration of the projection system (PL).

30. Apparatus according to claim 29, wherein said aberration of the projection system is particularly the spherical aberration, and more preferably the Zernike aberration component known as Z9.

31. An apparatus according to any one of claims 16 to 30, wherein the support structure (MT) comprises a mask table for holding a mask.

32. An apparatus according to any one of claims 16 to 31, wherein the radiation system comprises a radiation source (LA).

**Patentansprüche**

1. Verfahren zur Herstellung eines Bauteils, das folgende Schritte umfasst:

• Bereitstellen eines Substrats (W), das zumindest teilweise von einer Schicht aus strahlungssensitivem Material bedeckt ist;
• Bereitstellen eines Projektionsstrahls (PB) aus Strahlung unter Verwendung eines Strahlungssystems (LA, EX, IL);
• Verwenden von Musteraufbringungseinrichtungen (MA), um den Projektionsstrahl (PB) in seinem Querschnitt mit einem Muster zu versehen;
• Projizieren des gemusterten Strahls aus Strahlung auf einen Zielabschnitt (C) der Schicht aus strahlungssensitivem Material unter Verwendung eines Projektionssystems (PL);
• Erhalten von Informationen über Eigenschaften (Zj) von wenigstens einem von: dem Substrat (W), der Schicht aus strahlungssensitivem Material, dem Projektionsstrahl (PB), den Musteraufbringungseinrichtungen (MA) und dem Projektionssystem (PL); und
• Erhalten einer Vielzahl von Sensitivitätskoeffizienten (Ai; Bi; Ci; Di), die das Verhältnis zwischen den Eigenschaften und wenigstens einem aus einer Vielzahl von lithographischen Fehlern (dX, dY, dH, dV) in einem projizierten Bild in der strahlungssensitiven Schicht quantifiziert;

**gekennzeichnet durch**:

- Definieren einer Gütefunktion (S), die eine gewichtete Summe der Vielzahl von lithographischen Fehlern ist;
- Berechnen eines Kompensators (Cci), der bei wenigstens einer der Eigenschaften verwendet wird, um die Gütefunktion zu optimieren, wobei der Berechnungsschritt die Berechnung des Effekts auf die Gütefunktion des Kompensators auf der Basis einer linearen Approximation des Verhältnisses zwischen dem Kompensator und einer Änderung von Eigenschaften umfasst; und
- Verwenden des berechneten Kompensators bei wenigstens einer der Eigenschaften.

2. Verfahren zur Herstellung eines Bauteils nach Anspruch 1, wobei die Eigenschaften, über die Informationen erhalten werden, aus der Gruppe bestehend aus: Musterstrukturen; Maskenmusterfehlern; Aberration des Projektionssystems; Daten betreffend der strahlungssensitiven Schicht auf dem Substrat; Energie und Wellenlänge des Strahls aus Strahlung ausgewählt sind.

3. Verfahren zur Herstellung eines Bauteils nach Anspruch 1 oder 2, wobei der wenigstens eine lithographische Fehler ausgewählt ist aus der Gruppe bestehend aus: Merkmalsverschiebung in der X-Y-Ebene; Merkmalsrotation; asymmetrische Vergrößerung des Merkmals; Verzerrung; Verformung der Brennebene; asymmetrische Verteilung der kritischen Dimension über einen Zielabschnitt; Asymmetrie der kritischen Dimension hinsichtlich Defokussierung;

Links-Rechts-Asymmetrien der kritischen Dimension; L1-L2; L1-L5; Unterschiede kritischer Dimensionen zwischen Mustern, die im wesentlichen entlang zwei gegenseitig orthogonalen Richtungen ausgerichtet sind; Variation der kritischen Dimension innerhalb einer Struktur, entlang eines Balkens, im allgemeinen bekannt als C-D; und Kombinationen davon.

4. Verfahren zur Herstellung eines Bauteils nach Anspruch 1, 2 oder 3, wobei die Sensitivitätskoeffizienten lineare Konstanten von Proportionalität zwischen den Eigenschaften und den lithographischen Fehlern umfassen.

5. Verfahren zur Herstellung eines Bauteils nach einem der vorhergehenden Ansprüche, wobei die Sensitivitätskoeffizienten eine Vielzahl von Familien von Sensitivitätskoeffizienten umfassen für wenigstens eines von folgenden: verschiedene Beleuchtungseinstellungen des Strahlungssystems und/oder des Projektionssystems; und verschiedene Strukturen des zu projizierenden Musters.

6. Verfahren zur Herstellung eines Bauteils nach einem der vorhergehenden Ansprüche, wobei der Vorgang des Erhaltens wenigstens eines der folgenden enthält: Messen, Berechnen und Auslesen aus einer Datenbank.

7. Verfahren zur Herstellung eines Bauteils nach einem der vorhergehenden Ansprüche, wobei die Informationen über Eigenschaften eine Aberrationsfeldkarte als eine Funktion der Position in dem bei dem Zielabschnitt zu formenden Bild aufweisen.

8. Verfahren zur Herstellung eines Bauteils nach einem der vorhergehenden Ansprüche, wobei die Berechnung durchgeführt wird, um die Gütefunktion für die kritischste Struktur des zu projizierenden Musters zu optimieren.

9. Verfahren zur Herstellung eines Bauteils nach einem der vorhergehenden Ansprüche, wobei der Kompensator wenigstens eines von folgenden umfasst: Translation der Musteraufbringungseinrichtungen (MA); Rotation der Musteraufbringungseinrichtungen (MA); Translation des Substrats (W); Rotation des Substrats (W); Bewegung oder Deformation optischer Elemente, vorzugsweise optischer Elemente des Projektionssystems (PL); Ändern der Energie des Strahlungsstrahls; Ändern der Wellenlänge des Strahlungsstrahls (PB); Ändern des Brechungsindex von mit Gas gefüllten Zwischenräumen, die der Projektionsstrahl durchquert; Ändern der räumlichen Verteilung der Strahlungsintensität; Ändern des benutzten Feldbereichs.

10. Verfahren zur Herstellung eines Bauteils nach einem der vorhergehenden Ansprüche, wobei

• die Information über Eigenschaften eine Feldkarte der Aberration des Projektionssystems ist, die in Form der Zernike-Expansion ausgedrückt ist;
• der lithographische Fehler wenigstens eines von folgenden umfasst: die X-Verschiebung des Musters; die Y-Verschiebung des Musters; die Z-Verschiebung von Strukturen des in X-Richtung ausgerichteten Musters; und die Z-Verschiebung von Strukturen des in Y-Richtung ausgerichteten Musters, jedes als eine Funktion der Position in der X-Y-Ebene des Zielabschnitts des Substrats; und
• die Sensitivitätskoeffizienten die Proportionalitätskonstanten sind, die die Ansprechbarkeit des lithographischen Fehlers auf jede Zernike-Aberrationskomponente in der Expansion ergibt.

11. Verfahren zur Herstellung eines Bauteils nach einem der vorhergehenden Ansprüche, wobei:

• die Gütefunktion die Links-Rechts-Asymmetrie des Musters beschreibt;
• die Sensitivitätskoeffizienten die Links-Rechts-Asymmetrie auf die Position des Musters hinsichtlich des Vollfeldes des Projektionssystems beziehen; und
• der Kompensator die Anpassung der Position des Musters hinsichtlich des Vollfeldes des Projektionssystems ist.

12. Verfahren zur Herstellung eines Bauteils nach Anspruch 11, wobei der Kompensator eine Verschiebung des Musters in X-Richtung derart enthält, dass der gemusterte Strahl das Projektionssystem (PL) auf eine dezentralisierte Weise durchquert.

13. Verfahren zur Herstellung eines Bauteils nach einem der vorhergehenden Ansprüche, wobei :

• die Gütefunktion die Links-Rechts-Asymmetrie des Musters beschreibt;
• die Sensitivitätskoeffizienten die Proportionalitätskonstanten sind, die die Sensitivität der Links-Rechts-Asymmetrie auf die Aberration des Projektionssystems (PL) ergeben; und

• der Kompensator die Anpassung der linearen komatischen Aberration des Projektionssystems (PL) ist.

14. Verfahren zur Herstellung eines Bauteils nach einem der vorhergehenden Ansprüche, wobei:

• die Musteraufbringungseinrichtungen (MA) eine Phasenverschiebungsmaske umfasst;
• die Informationen über Eigenschaften den Phasenverschiebungsfehler der Phasenverschiebungsmaske umfassen;
• die Gütefunktion des Bossung-Tilts beschreibt;
• die Sensitivitätskoeffizienten die Proportionalitätskonstanten sind, die die Sensitivität des Bossung-Tilts zum Phasenverschiebungsfehler und zur Aberration des Projektionssystems (PL) ergeben; und
• der Kompensator die Anpassung der Aberration des Projektionssystems (PL) ist.

15. Verfahren zur Herstellung eines Bauteils nach Anspruch 12, wobei die Aberration des Projektionssystems insbesondere die sphärische Aberration und bevorzugter Weise die Zernike-Aberrationskomponente ist, die als Z9 bekannt ist.

16. Lithographische Projektionsvorrichtung, mit:

• einem Strahlungssystem (LA, EX, IL) zum Bereitstellen eines Projektionsstrahls (PB) aus Strahlung;
• einer Haltekonstruktion (MT) zum Halten einer Musteraufbringungseinrichtung (MA), wobei die Musteraufbringungseinrichtung (MA) dazu dient, den Projektionsstrahl (PB) gemäß einem gewünschten Muster zu mustern;
• einem Substrattisch (WT) zum Halten eines Substrats (W);
• einem Projektionssystem (PL) zum Projizieren des gemusterten Strahls (PB) auf einen Zielabschnitt des Substrats (W);
• Kompensationseinrichtungen, die bei wenigstens einem von der Haltekonstruktion (MT) zum Halten der Musteraufbringungseinrichtung (MA), dem Substrattisch (WT), dem Strahlungssystem (LA, EX, IL), der Musteraufbringungseinrichtung (MA) und dem Projektionssystem (PL) anwendbar ist, um eine Gütefunktion zu optimieren, die lithographische Fehler gewichtet und summiert, die eine Anomalie in einem projizierten Bild in der strahlungssensitiven Schicht hervorruft; und
• einem Prozessor zum Berechnen wenigstens eines Kompensators, der durch die Kompensationseinrichtung gemäß dem in Anspruch 1 definierten Berechnungsschritt anzuwenden ist.

17. Vorrichtung nach Anspruch 16, wobei die Eigenschaften aus der Gruppe bestehend aus: Maskenstrukturen; Maskenmusterfehlern; der Aberration des Projektionssystems; Daten bezüglich der strahlungssensitiven Schicht auf dem Substrat; Energie und Wellenlänge des Strahlungsstrahls ausgewählt sind.

18. Vorrichtung nach Anspruch 16 oder 17, wobei der wenigstens eine lithographische Fehler aus der Gruppe bestehend aus: Merkmalsverschiebung in der X-Y-Ebene; Merkmalsrotation; asymmetrische Merkmalsvergrößerung; Verzerrung; Verformung der Brennebene; asymmetrische Verteilung von CD über einen Zielabschnitt; Asymmetrie kritischen Dimension hinsichtlich Defokussierung; Links-Rechts-Asymmetrien der kritischen Dimension; L1-L2; L1-L5; Unterschiede der kritischen Dimension zwischen Mustern, die im wesentlichen entlang zwei gegenseitig orthogonalen Richtungen ausgerichtet sind; Variation der kritischen Dimension innerhalb einer Struktur, entlang eines Balkens, im allgemeinen bekannt als C-D; und Kombinationen davon ausgewählt ist.

19. Vorrichtung nach Anspruch 16, 17 oder 18, wobei die Sensitivitätskoeffizienten lineare Proportionalitätskonstanten zwischen den Eigenschaften und dem lithographischen Fehler umfassen.

20. Vorrichtung nach einem der Ansprüche 16 bis 19, wobei die Sensitivitätskoeffizienten eine Vielzahl von Familien von Sensitivitätskoeffizienten umfassen für wenigstens eines von: verschiedene Beleuchtungseinstellungen des Strahlungssystems und/oder des Projektionssystems; und verschiedene Strukturen des zu projizierenden Musters.

21. Vorrichtung nach einem der Ansprüche 16 bis 20, ferner mit einer Datenbank der Sensitivitätskoeffizienten und/oder der Eigenschaften.

22. Vorrichtung nach einem der Ansprüche 16 bis 21, wobei die Eigenschaften eine Aberrationsfeldkarte als eine Funktion der Position in dem bei dem Zielabschnitt zu formenden Bild aufweisen.

**23.** Vorrichtung nach einem der Ansprüche 16 bis 22, wobei der Prozessor so angeordnet ist, dass er die Berechnung durchzuführt, um die Gütefunktion für die kritischste Struktur des zu projizierenden Musters zu optimieren.

**24.** Vorrichtung nach einem der Ansprüche 16 bis 23, wobei der Kompensator wenigstens eines von folgenden umfasst: Translation der Musteraufbringungseinrichtungen (MA); Rotation der Musteraufbringungseinrichtungen (MA); Translation des Substrats (W); Rotation des Substrats (W); Bewegung oder Deformation optischer Elemente, vorzugsweise optischer Elemente des Projektionssystems (PL); Ändern der Energie des Strahlungsstrahls; Ändern der Wellenlänge des Strahlungsstrahls; Ändern des Brechungsindex von mit Gas gefüllten Zwischenräumen, die der Projektionsstrahl (PB) durchquert; Ändern der räumlichen Verteilung der Strahlungsintensität; Ändern des benutzten Feldbereichs.

**25.** Vorrichtung nach einem der Ansprüche 16 bis 24, wobei:

• die Eigenschaften eine Aberrationsfeldkarte des Projektionssystems (PL) ist, die in Form der Zernike-Expansion ausgedrückt ist;
• der lithographische Fehler wenigstens eines von folgenden umfasst: die X-Verschiebung des Musters; die Y-Verschiebung des Musters; die Z-Verschiebung von Strukturen des in X-Richtung ausgerichteten Musters; und die Z-Verschiebung von Strukturen des in Y-Richtung ausgerichteten Musters, jedes als eine Funktion der Position in der X-Y-Ebene des Zielabschnitts des Substrats; und
• die Sensitivitätskoeffizienten die Proportionalitätskonstanten sind, die die Ansprechbarkeit des lithographischen Fehlers auf jede Zernike-Aberrationskomponente in der Expansion ergeben.

**26.** Vorrichtung nach einem der Ansprüche 16 bis 25, wobei:

• die Gütefunktion die Links-Rechts-Asymmetrie des Musters beschreibt;
• die Sensitivitätskoeffizienten die Links-Rechts-Asymmetrie auf die Position des Musters hinsichtlich des Vollfeldes des Projektionssystems beziehen; und
• der Kompensator die Anpassung der Position des Musters hinsichtlich des Vollfeldes des Projektionssystems ist.

**27.** Vorrichtung nach Anspruch 26, wobei der Kompensator eine Verschiebung des Musters in X-Richtung derart enthält, dass der gemusterte Strahl das Projektionssystem (PL) auf eine dezentralisierte Weise durchquert.

**28.** Vorrichtung nach einem der Ansprüche 16 bis 27, wobei:

• die Gütefunktion die Links-Rechts-Asymmetrie des Musters beschreibt;
• die Sensitivitätskoeffizienten die Proportionalitätskonstanten sind, die die Sensitivität der Links-Rechts-Asymmetrie auf die Aberration des Projektionssystems (PL) ergeben; und
• der Kompensator die Anpassung der linearen komatischen Aberration des Projektionssystems (PL) ist.

**29.** Vorrichtung nach einem der Ansprüche 16 bis 28, wobei:

• die Musteraufbringungseinrichtungen (MA) eine Phasenverschiebungsmaske umfassen;
• die Eigenschaften den Phasenverschiebungsfehler der Phasenverschiebungsmaske umfassen;
• die Gütefunktion der Bossung-Tilt beschreibt;
• die Sensitivitätskoeffizienten die Proportionalitätskonstanten sind, die die Sensitivität des Bossung-Tilts auf Phasenverschiebungsfehler und auf die Aberration des Projektionssystems (PL) ergeben; und
• der Kompensator die Anpassung der Aberration des Projektionssystems (PL) ist.

**30.** Vorrichtung nach Anspruch 29, wobei die Aberration des Projektionssystems insbesondere die sphärische Aberration und bevorzugter Weise die Zernike-Aberrationskomponente ist, die als Z9 bekannt ist.

**31.** Vorrichtung nach einem der Ansprüche 16 bis 30 ist, wobei die Haltekonstruktion (MT) einen Maskentisch zum Halten einer Maske umfasst.

**32.** Vorrichtung nach einem der Ansprüche 16 bis 31, wobei das Strahlungssystem eine Strahlungsquelle (LA) umfasst.

**Revendications**

1. Procédé de fabrication d'un dispositif comprenant les étapes suivantes :

   prévoir un substrat (W) qui est au moins partiellement recouvert d'une couche d'un matériau sensible au rayonnement ;
   fournir un faisceau de projection (PB) d'un rayonnement en utilisant un système de rayonnement (LA, EX, IL) ;
   utiliser des moyens de mise en forme (MA) pour doter le faisceau de projection (PB) d'un motif dans sa section transversale ;
   projeter le faisceau de rayonnement configuré sur une partie cible (c) de la couche de matériau sensible au rayonnement en utilisant un système de projection (PL),
   obtenir des informations sur des propriétés (Zj) d'au moins un parmi le substrat (W), la couche de matériau sensible au rayonnement, le faisceau de projection (PB), les moyens de mise en forme (MA) et le système de projection (PL) ; et
   obtenir une pluralité de coefficients de sensibilité (Ai, Bi, Ci, Di) qui quantifient la relation entre lesdites propriétés et au moins une parmi une pluralité d'erreurs lithographiques (dX, dY, dH, dV) dans une image projetée dans la couche sensible au rayonnement ;

   **caractérisé par** :

   la définition d'une fonction de mérite (S) qui est une somme pondérée de ladite pluralité d'erreurs lithographiques ;
   le calcul d'un compensateur (C'i) à appliquer à au moins une desdites propriétés pour optimiser la fonction de mérite, ladite étape de calcul comprenant le calcul de l'effet sur la fonction de mérite du compensateur sur la base d'une approximation linéaire de la relation entre le compensateur et un changement de propriétés ; et
   l'application du compensateur calculé à au moins une desdites propriétés.

2. Procédé de fabrication d'un dispositif selon la revendication 1, dans lequel lesdites propriétés sur lesquelles des informations sont obtenues sont sélectionnées dans le groupe consistant en : des caractéristiques de motif ; des erreurs de motif de masque ; l'aberration du système de projection ; des données concernant la couche sensible au rayonnement sur le substrat ; l'énergie et la longueur d'onde du faisceau de rayonnement.

3. Procédé de fabrication d'un dispositif selon la revendication 1 ou 2, dans lequel ladite au moins une erreur lithographique est sélectionnée dans le groupe consistant en : un déplacement de caractéristique dans le plan X,Y ; une rotation de caractéristique ; un agrandissement asymétrique de caractéristique ; la distorsion ; la déformation du plan focal ; la répartition asymétrique de CD sur une partie cible ; l'asymétrie de CD par rapport à la défocalisation ; les asymétries gauche/droite de CD ; L1-L2 ; L1-L5 ; des différences de CD entre des motifs qui sont sensiblement dirigés le long de deux directions mutuellement orthogonales ; la variation de CD à l'intérieur d'une caractéristique, le long d'une barre, couramment connue sous le nom de C-D ; et des combinaisons de ceux-ci.

4. Procédé de fabrication d'un dispositif selon la revendication 1, 2 ou 3, dans lequel lesdits coefficients de sensibilité comprennent des constantes linéaires de proportionnalité entre lesdites propriétés et lesdites erreurs lithographiques.

5. Procédé de fabrication d'un dispositif selon l'une quelconque des revendications précédentes, dans lequel lesdits coefficients de sensibilité comprennent une pluralité de familles de coefficients de sensibilité pour au moins un parmi : des paramétrages d'éclairage différents du système de rayonnement et/ou du système de projection ; et des caractéristiques différentes du motif à projeter.

6. Procédé de fabrication d'un dispositif selon l'une quelconque des revendications précédentes, dans lequel le procédé d'obtention comprend au moins un parmi : la mesure ; le calcul ; et la lecture sur une base de données.

7. Procédé de fabrication d'un dispositif selon l'une quelconque des revendications précédentes, dans lequel lesdites informations sur les propriétés comprennent une carte de champ d'aberration comme une fonction d'une position dans l'image devant être formée au niveau de ladite partie cible.

8. Procédé de fabrication d'un dispositif selon l'une quelconque des revendications précédentes, dans lequel ledit calcul est réalisé pour optimiser la fonction de mérite pour la caractéristique la plus critique du motif à projeter.

**EP 1 251 402 B1**

**9.** Procédé de fabrication d'un dispositif selon l'une quelconque des revendications précédentes, dans lequel le compensateur comprend au moins un parmi : la translation des moyens de mise en forme (MA) ; la rotation des moyens de mise en forme (MA) ; la translation du substrat (W) ; la rotation du substrat (W) ; le mouvement ou la déformation d'éléments optiques, de préférence d'éléments optiques du système de projection (PL) ; le changement d'énergie du faisceau de rayonnement ; le changement de longueur d'onde du faisceau de rayonnement (PB) ; le changement d'indice de réfraction d'espaces remplis de gaz traversés par le faisceau de projection ; le changement de la répartition spatiale de l'intensité du rayonnement ; le changement d'une partie utilisée du champ.

**10.** Procédé de fabrication d'un dispositif selon l'une quelconque des revendications précédentes, dans lequel :

lesdites informations sur les propriétés sont carte de champ d'aberration du système de projection exprimée en termes de l'expansion de Zernike ;
ladite erreur lithographique comprend au moins un parmi : le déplacement X du motif ; le déplacement Y du motif ; le déplacement Z de caractéristiques du motif orientées dans le sens des X ; et le déplacement Z de caractéristiques du motif orientées dans le sens des Y, chacun comme une fonction de la position dans le plan X,Y de la partie cible du substrat ; et
lesdits coefficients de sensibilité sont les constantes de proportionnalité donnant la sensibilité de l'erreur lithographique à chaque composante d'aberration de Zernike dans ladite expansion.

**11.** Procédé de fabrication d'un dispositif selon l'une quelconque des revendications précédentes, dans lequel :

ladite fonction de mérite décrit l'asymétrie gauche/droite du motif ;
lesdits coefficients de sensibilité mettent en relation l'asymétrie gauche/droite avec la position du motif par rapport au champ entier du système de projection ; et
ledit compensateur est un ajustement de la position du motif par rapport au champ entier du système de projection.

**12.** Procédé de fabrication d'un dispositif selon la revendication 11, dans lequel ledit compensateur comprend un décalage du motif dans le sens des X, de telle sorte que le faisceau configuré traverse le système de projection (PL) de manière décentrée.

**13.** Procédé de fabrication d'un dispositif selon l'une quelconque des revendications précédentes, dans lequel :

ladite fonction de mérite décrit l'asymétrie gauche/droite du motif ;
lesdits coefficients de sensibilité sont les constantes de proportionnalité donnant la sensibilité de l'asymétrie gauche/droite à l'aberration du système de projection (PL) ; et
ledit compensateur est un ajustement de l'aberration comatique linéaire du système de projection (PL).

**14.** Procédé de fabrication d'un dispositif selon l'une quelconque des revendications précédentes, dans lequel:

lesdits moyens de mise en forme (MA) comprennent un masque de déphasage ;
lesdites informations sur les propriétés comprennent l'erreur de déphasage du masque de déphasage ;
ladite fonction de mérite décrit l'inclinaison de Bossung ;
lesdits coefficients de sensibilité sont les constantes de proportionnalité donnant la sensibilité de l'inclinaison de Bossung à l'erreur de déphasage et à l'aberration du système de projection (PL) ; et
ledit compensateur est un ajustement de l'aberration du système de projection (PL).

**15.** Procédé de fabrication d'un dispositif selon la revendication 12, dans lequel ladite aberration du système de projection est en particulier l'aberration sphérique, et de manière préférée la composante d'aberration de Zernike connue sous le nom de Z9.

**16.** Appareil de projection lithographique comprenant :

un système de rayonnement (LA, EX, IL) pour fournir un faisceau de projection (PB) de rayonnement ;
une structure de support (MT) pour soutenir les moyens de mise en forme (MA), les moyens de mise en forme (MA) servant à mettre en forme le faisceau de projection (PB) selon un motif souhaité ;
une table de substrat (WT) pour soutenir un substrat (W) ;
un système de projection (PL) pour projeter le faisceau mis en forme (PB) sur une partie cible du substrat (W),

des moyens de compensation applicables à au moins un parmi la structure de support (MT) pour soutenir les moyens de mise en forme (MA), la table de substrat (WT), le système de rayonnement (LA, EX, IL), les moyens de mise en forme (MA) et le système de projection (PL), pour optimiser une fonction de mérite qui pondère et additionne des erreurs lithographiques entraînant une anomalie dans une image projetée dans la couche sensible au rayonnement ; et

un processeur pour calculer au moins un compensateur devant être appliqué par lesdits moyens de compensation selon l'étape de calcul définie dans la revendication 1.

17. Appareil selon la revendication 16, dans lequel lesdites propriétés sont sélectionnées dans le groupe consistant en : des caractéristiques de motif ; des erreurs de motif de masque ; l'aberration du système de projection; des données concernant la couche sensible au rayonnement sur le substrat ; l'énergie et la longueur d'onde du faisceau de rayonnement.

18. Appareil selon la revendication 16 ou 17, dans lequel ladite au moins une erreur lithographique est sélectionnée dans le groupe consistant en: un déplacement de caractéristique dans le plan X,Y ; une rotation de caractéristique; un agrandissement asymétrique de caractéristique; la distorsion; la déformation du plan focal ; la répartition asymétrique de CD sur une partie cible ; l'asymétrie de CD par rapport à la défocalisation ; des asymétries gauche/droite de CD ; L1-L2 ; L1-L5 ; des différences de CD entre des motifs qui sont sensiblement dirigés le long de deux directions mutuellement orthogonales ; la variation de CD à l'intérieur d'une caractéristique, le long d'une barre, couramment connue sous le nom de C-D et des combinaisons de ceux-ci.

19. Appareil selon la revendication 16, 17 ou 18, dans lequel lesdits coefficients de sensibilité comprennent des constantes linéaires de proportionnalité entre lesdites propriétés et ladite erreur lithographique.

20. Appareil selon l'une quelconque des revendications 16 à 19, dans lequel lesdits coefficients de sensibilité comprennent une pluralité de familles de coefficients de sensibilité pour au moins un parmi : des paramétrages d'éclairage différents du système de rayonnement et/ou du système de projection ; et des caractéristiques différentes du motif à projeter.

21. Appareil selon l'une quelconque des revendications 16 à 20, comprenant en outre une base de données desdits coefficients de sensibilité et/ou desdites propriétés.

22. Appareil selon l'une quelconque des revendications 16 à 21, dans lequel lesdites propriétés comprennent une carte de champ d'aberration comme une fonction de la position dans l'image devant être formée au niveau de ladite partie cible.

23. Appareil selon l'une quelconque des revendications 16 à 22, dans lequel ledit processeur est agencé pour effectuer ledit calcul pour optimiser la fonction de mérite pour la caractéristique la plus critique du motif à projeter.

24. Appareil selon l'une quelconque des revendications 16 à 23, dans lequel le compensateur comprend au moins un parmi : la translation des moyens de mise en forme (MA) ; la rotation des moyens de mise en forme (MA) ; la translation du substrat (W) ; la rotation du substrat (W) ; le mouvement ou la déformation des éléments optiques, de préférence d'éléments optiques du système de projection (PL) ; le changement d'énergie du faisceau de rayonnement ; le changement de la longueur d'onde du faisceau de rayonnement ; le changement de l'indice de réfraction d'espaces remplis de gaz traversés par le faisceau de projection (PB) ; le changement de la répartition spatiale de l'intensité du rayonnement ; le changement d'une partie de champ utilisée.

25. Appareil selon l'une quelconque des revendications 16 à 24, dans lequel :

lesdites propriétés comprennent une carte de champ d'aberration du système de projection (PL) exprimée en termes de l'expansion de Zernike ;
ladite erreur lithographique comprend au moins un parmi le point de déplacement X du motif ; le déplacement Y du motif ; le déplacement Z de caractéristiques du motif orienté dans le sens des X ; et le déplacement Z de caractéristiques du motif orienté dans le sens des Y, chacun en tant qu'une fonction de la position dans le plan X,Y de la partie cible du substrat ; et
lesdits coefficients de sensibilité sont les constantes de proportionnalité donnant la sensibilité de l'erreur lithographique à chaque composante d'aberration de Zernike dans ladite expansion.

**26.** Appareil selon l'une quelconque des revendications 16 à 25, dans lequel :

ladite fonction de mérite décrit l'asymétrie gauche/droite du motif ;
lesdits coefficients de sensibilité mettent en relation l'asymétrie gauche/droite avec la position du motif par rapport au champ entier du système de projection ; et
ledit compensateur est un ajustement de la position du motif par rapport au champ entier du système de projection.

**27.** Appareil selon la revendication 26, dans lequel ledit compensateur comprend un décalage du motif dans le sens des X, de telle sorte que le faisceau configuré traverse le système de projection (PL) d'une manière décentrée.

**28.** Appareil selon l'une quelconque des revendications 16 à 27, dans lequel :

ladite fonction de mérite décrit l'asymétrie gauche/droite du motif ;
lesdits coefficients de sensibilité sont les constantes de proportionnalité donnant la sensibilité de l'asymétrie gauche/droite à l'aberration du système de projection (PL) ; et
ledit compensateur est un ajustement de l'aberration linéaire comatique du système de projection (PL).

**29.** Appareil selon l'une quelconque des revendications 16 à 28, dans lequel :

lesdits moyens de mise en forme (MA) comprennent un masque de déphasage ;
lesdites propriétés comprennent l'erreur de déphasage du masque de déphasage ;
ladite fonction de mérite décrit l'inclinaison de Bossung ;
lesdits coefficients de sensibilité sont les constantes de proportionnalité donnant la sensibilité de l'inclinaison de Bossung à l'erreur de déphasage et à l'aberration du système de projection (PL) ; et
ledit compensateur est un ajustement de l'aberration du système de projection (PL).

**30.** Appareil selon la revendication 29, dans lequel ladite aberration du système de projection est en particulier l'aberration sphérique, et de manière préférée la composante d'aberration de Zernike connue sous le nom de Z9.

**31.** Appareil selon l'une quelconque des revendications 16 à 30, dans lequel la structure de support (MT) comprend une table de masque pour soutenir un masque.

**32.** Appareil selon l'une quelconque des revendications 16 à 31, dans lequel le système de rayonnement comprend une source de rayonnement (LA).

# Fig.1.

# Fig.2.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5296891 A
- US 5523193 A
- WO 9838597 A
- WO 9833096 A
- US 5229872 A
- US 6046792 A
- US 5969441 A
- WO 9840791 A
- US 6115108 A
- EP 1128217 A2

**Non-patent literature cited in the description**

- **PETER VAN ZANT.** Microchip Fabrication: A Practical Guide to Semiconductor Processing. McGraw Hill Publishing Co, 1997
- **P. VENKATARAMAN et al.** Aberrations of steppers using Phase Shifting Point Diffraction Interferometry. *Optical Microlithography XIII,* 2000, vol. 4000, 1245-1249
- **WILLIAM H. PRESS ; BRIAN P. FLANNERY ; SAUL A. TEUKOLSKY ; WILLIAM T. VETTER-LING.** Numerical Recipes in C. Cambridge University Press, 1988